# EUROPÄISCHE PATENTSCHRIFT

(11) **EP 0 419 942 B1**
(45) Veröffentlichungstag und Bekanntmachung des Hinweises auf die Patenterteilung: **10.12.1997**
(21) Anmeldenummer: 90117558.8
(22) Anmeldetag: 12.09.1990
(51) Int. Cl.: H03M 1/12, G01R 23/02

(54) **Frequenz-Digital-Wandler**
Frequency-digital converter
Convertisseur à fréquence numérique

(30) Priorität: 26.09.1989 DE 3931980
(43) Veröffentlichungstag der Anmeldung: 03.04.1991
(73) Patentinhaber: Bodenseewerk Gerätetechnik GmbH, 88662 Überlingen (DE)
(72) Erfinder: Marschall, Klaus, D-7758 Meersburg (DE)
(74) Vertreter: Wolgast, Rudolf, Dipl.-Chem. Dr.

(56) Entgegenhaltungen:
- DE-A- 3 018 463
- DE-A- 3 033 405
- US-A- 4 330 746
- US-A- 4 517 637
- NEW ELECTRONICS.INCORPORATING ELECTRONICS TODAY Bd. 16, Nr. 16, August 1983, LONDON GB Seiten 57 - 59 TEAGUE 'A/D conversion isn't as easy as it appears to be'

## Beschreibung

### Technisches Gebiet

Die Erfindung betrifft eine Schaltungsanordnung zur Frequenz-Digital-Wandlung.

### Zugrundeliegender Stand der Technik

Es sind verschiedene Verfahren bekannt, Frequenzen in ein Digitalwort umzusetzen.

Ein Verfahren ist das "Zählverfahren": Ein Zähler zählt die Flanken einer zu messenden Frequenz während einer bestimmten, vorgegebenen Zeit. Diese Zeit (Torzeit) wird mittels einer Referenzfrequenz bestimmt. Es wird dazu eine vorgegebene Zahl von Zyklen dieser Referenzfrequenz abge zählt.

Ein anderes Verfahren zur Frequenz-Digital-Wandlung ist das "Zeitverfahren". Dabei wird innerhalb eines Tores, gebildet aus einem oder mehreren Zyklen der zu messenden Frequenz die Zeit durch Auszählen einer Referenzfrequenz bestimmt.

Schließlich gibt es ein kombiniertes Zähl- und Zeit verfahren. Dabei werden nach dem Zählverfahren die Flanken der zu messenden Frequenz gezählt. Nach dem Ablauf der Torzeit wird die Zeit bis zum nächsten vollen Zyklus der zu messenden Frequenz ermittelt.

Die bekannten Verfahren werden nach dem Stand der Technik mit einer Mehrzahl von diskreten, handelsüblichen Bauelementen, wie Zählern, aufgebaut. Das bedingt einen hohen Raumbedarf. Die Fertigung ist aufwendig und teuer. Durch die große Anzahl verschiedener Bauelemente ist die Zuverlässigkeit eines solchen Frequenz-Digital-Wandlers gering. Außerdem ist ein solcher Frequenz-Digital-Wandler schwer zu testen.

In der DE-A-30 18 463 und der US-A-4 330 746 sind Schaltungen beschrieben, die nach dem vorerwähnten kombinierten Zähl- und Zeitverfahren arbeiten.

Die US-A-4 107 600 beschreibt eine Anordnung zur Umwandlung einer als Wechselstromfrequenz vorliegenden Information in digitale Daten. Zu diesem Zweck wird eine Impulsfolge mit bekannter Frequenz erzeugt. Während einer bestimmten Periode der Wechselstromfrequenz wird die Anzahl der auftretenden Impulse gezählt. Das liefert einen Digitalwert proportional der Wechselstromfrequenz. Nach der US-A-4 107 600 wird die Frequenz der Impulsfolge optimiert. Das entspricht dem oben geschilderten "Zeitverfahren" Auch diese Anordnung ist mit diskreten Schaltungsbausteinen aufgebaut.

Die US-A-4 123 704 beschreibt eine aus diskreten Bauteilen aufgebaute Anordnung zum Vergleich einer zu überwachenden Frequenz und einer Referenzfrequenz. Die Abweichung der zu überwachenden Frequenz von der Referenzfrequenz wird digital angezeigt.

Die DE-A-30 33 405 betrifft ein Verfahren zur analogdigitalen Meßwertwandlung und zum Vergleich mit wählbaren digitalen Grenzwerten. Dabei wird der Meßwert in eine dazu proportionale Frequenz umgewandelt. Die Impulse dieser Frequenz werden von einer Steuerlogik gesteuert in einem Vor- und Rückwärtszähler gezählt, nach der Zählung in einen Speicher übertragen und in einer Digitalanzeige angezeigt. Das entspricht der oben geschilderten Frequenz- Digital-Wandlung nach dem Zählverfahren. Die Steuerlogik erhält oder erzeugt einen Takt, der den letzten gebildeten digitalen Meßwert einschließlich Vorzeichen in einen Speicher überführt, den Vor- und Rückwärtszähler und ein Vorzeichenflipflop auf einen Anfangswert setzt und mit dem Beginn der Meßwertwandlung die meßwertproportionale Frequenz je nach dem Vorzeichen des Anfangswertes auf einen der beiden Eingänge des Vor- und Rückwärtszählers schaltet. Von einer Nulltestschaltung wird ein Impuls abgegeben, wenn bei negativem Anfangswert der Zählerstand null des Vor- und Rückwärtszählers vorliegt. Dieser Impuls der Nulltestschaltung schaltet das Vorzeichenflipflop um. Außerdem kehrt dieser Impuls die Zählrichtung um. Die Steuerlogik beendet nach einer bestimmten Zeit die Meßwertwandlung. Der nach der Meßwertwandlung in den Speicher übernommene digitale Meßwert gelangt über einen Siebensegmentdecoder auf die Digitalanzeige. Außerdem liegt der digitale Meßwert einschließlich eines Meßendeimpulses an einem Ausgang zur weiteren Verarbeitung an. Der Betrag des gespeicherten digitalen Meßwertes wird durch zwei Vergleichsschaltungen verglichen mit den Beträgen zweier digitaler Grenzwerte. Dadurch werden Signale erzeugt, die ein Unter- oder Überschreiten des durch die Grenzwerte begrenzten Bereiches erkennen lassen.

Durch "Unterrichtsblätter der Deutschen Bundespost, Ausgabe B Fernmeldewesen" 38 Jahrgang (1985), Seite 305 ist ein integrierter Zählerbaustein bekannt. Der integrierte Zählerbaustein enthält einen Zähler und ein Register. Zähler und Register sind durch Eingangs-Multi plexer mit Eingängen verbunden. Der Zählerstand ist auf einen Speicher aufschaltbar. Der Speicher ist über einen Ausgangs-Multiplexer mit Ausgängen sowie einem Sieben segmentdecoder verbunden. Zählerstand und Inhalt des Registers sind auf einen Vergleicher geschaltet. Der Vergleicher liefert ein Signal an einem Vergleicheraus gang. Der integrierte Baustein enthält weiter einen Oszillator und Zähler zur Ansteuerung der Multiplexer.

### Offenbarung der Erfindung

Der Erfindung liegt die Aufgabe zugrunde, eine Schaltungsanordnung zur Frequenz- Digital-Wandlung zu schaffen, die in der Gerätefertigung einfacher zu handhaben ist und geringeren Raumbedarf hat als vorbekannte Frequenz-Digital-Wandler, die höhere Zuverlässigkeit besitzt und einfach getestet werden kann und deren Wandlerverhalten und Wandlerbereich flexibel programmiert werden kann.

Weiterhin soll der Frequenz-Digital-Wandler in der Lage sein, eine anliegende Frequenz auf Überschreiten eines Grenzwertes zu überwachen.

Erfindungsgemäß wird diese Aufgabe durch die in Patentanspruch 1 angegebenen Maßnahmen gelöst.

Es wird also ein spezieller Baustein für die Frequenz-Digital-Wandlung geschaffen. Das bringt eine Verbilligung, eine Verminderung des benötigten Volumens und des Gewichts. Die Zuverlässigkeit wird erhöht und die Test möglichkeit und Wartung wird erleichtert.

Der Baustein kann in Verbindung mit einem Prozessor (Mikroprozessor) benutzt werden. Er kann dann für seine spezielle Aufgabe wie Wandelverhalten und Frequenzmeß bereich von dem Prozessor programmiert werden. Er setzt dann eine an seinem Eingang anliegende, zu messende Frequenz in ein digitales Wort um und stellt dieses digitale Wort dem Prozessor zur Auslesung bereit.

Der Baustein kann aber auch prozessorunabhängig arbeiten. Der Baustein kann sich dann aus einem Datenspeicher, z.B. einem EPROM, für seine spezielle Aufgabe, z.B. für ein bestimmtes Wandlerverhalten oder einen speziellen Frequenzmeßbereich selbst programmieren.

Der Baustein ist in der Lage, eine an seinem Eingang anliegende Frequenz auf Überschreiten eines Grenzwertes zu überwachen.

Ein solcher Baustein kann benutzt werden zur schnellen und genauen Wandlung von Frequenzen in ein digitales Wort. Der Baustein kann auch dazu dienen, maximale Frequenzwerte selbständig zu überwachen und zu melden. Mit einem vorge schalteten Analogwert-Frequenz-Wandler kann der Baustein zum Aufbau eines Analog-Digital-Wandlers dienen. Diese Anwendungen sind in allen Geräten möglich, in denen Frequenzen oder Spannungen von einem Prozessor (Micro prozessor) erfaßt werden sollen.

Beispiele für solche Anwendungen sind Triebwerksregler. Es können dort Drehzahlen von Triebwerken, die von ihren Sensoren üblicherweise als variable Frequenzen ausgegeben werden, in digitale Worte umgesetzt werden. Ebenso können mit einem Frequenz-Digital-Wandler Temperaturen von Quarz kristall-Temperatursensoren in digitale Worte umgesetzt werden. Eine weitere Anwendung ist die Messung von Temperaturen und Drücken in Triebwerken. Diese Größen werden von den Sensoren in Form kleiner Spannungen ausgegeben. Diese Spannungen können durch einen Spannungs-Frequenz-Wandler in Frequenzen umgesetzt und fernüber tragen werden. Der Frequenz-Digital-Wandler setzt diese Frequenzen wieder in digitale Worte um.

Um z.B. bei Triebwerken Überdrehzahlen oder Übertempera turen ohne Prozessorsteuerung verhindern zu können, weist der Baustein ein eigenständiges Meß- und Vergleichsver halten auf.

Ausgestaltungen der Erfindung sind Gegenstand der abhängigen Patentansprüche.

Ein Ausführungsbeispiel der Erfindung ist nachstehend unter Bezugnahme auf die zugehörige Zeichnung näher erläutert, die ein Blockdiagramm einer Schaltungsanordnung zur Frequenz-Digital- Wandlung zeigt.

### Bevorzugte Ausführung der Erfindung

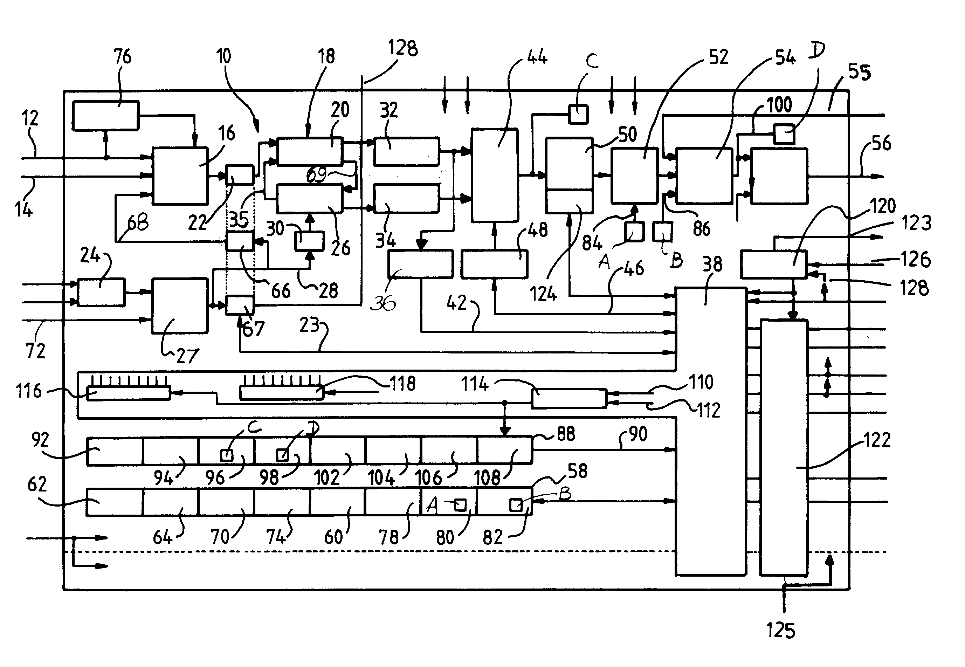

In der Figur ist ein Wandlerkanal 10 im einzelnen dargestellt. Der Wandlerkanal 10 hat zwei Eingänge 12 und 14 für zu wandelnde Frequenzen FM1 und FM2. Die Eingänge 12 und 14 sind über einen Multiplexer 16 auf einen Frequenz-Digital-Wandler 18 aufschaltbar.

Mit 38 ist eine Prozessor-Bus-Schnittstelle bezeichnet. Ein Prozessor setzt über die Prozessor-Bus-Schnittstelle 38 das Start-Bit 78 im Kommandoregister 58
- einmalig im Asynchron-Modus (Bit 60 im Kommandoregister 58 auf "Null")
- vor jeder Wandlung im Synchron-Modus (Bit 60 im Kommandoregister 58 auf "Eins")
und gibt somit den Torzeitzähler 26 frei, der wiederum den Flankenzähler 20 freigibt. Bei der nächsten auftretenden positiven Flanke der Meßfrequenz FM fangen dann beide Zähler an zu zählen.

Der Frequenz-Digital-Wandler 18 enthält einen ersten Zähler 20 (Flankenzähler) auf welchen über einen Frequenzbereichsteiler 22 die von dem Multiplexer 16 durchgeschaltete Frequenz von Eingang 12 oder Eingang 14 aufschaltbar ist. Der Torzeitzähler 26 erhält eine Referenzfrequenz FR2, die von dem Teiler 30 halbiert wird von einem Oszillator 24 oder einem Eingang 72 über einen Multiplexer 27. Er gibt den Flankenzähler 20 frei, der die Flanken der Frequenz FM1 oder FM2 zählt. Wenn der Torzeitzähler 26 durch Abzählen einer vorgegebenen, festen Anzahl von Referenzfrequenzimpulsen die Torzeit erreicht hat, sperrt er über Leitung 35 den Flankenzähler 20. Er selbst zählt aber weiter bis zur nächsten vollen Periodenflanke der Meßfrequenz. Dann wird auch der Torzeitzähler 26 über Leitung 69 angehalten. "Torzeit" ist dabei die Zeit, während welcher der Torzeitzähler 26 die Frequenz FM zu dem Zähler 20 durchläßt. Der Torzeitzähler 26 liefert einen Zählerstand, der auch den "Bruchteil" der letzten, unvollständigen Periode der Meßfrequenz erfaßt, welcher nicht mehr in die Torzeit gefallen ist. Der Flankenzähler 20 liefert somit ein Maß für die höherwertigen Stellen des die zu messende Frequenz wiedergebenden digitalen Wortes, während der zweite Zähler 26 ein Maß für die geringerwertigen Stellen dieses digitalen Wortes liefert. Die Zählerstände der beiden Zähler 20 und 26 werden auf Zwischenspeicher 32 bzw. 34 übertragen.

Der Inhalt der Zwischenspeicher 32 und 34 wird in einem Zwischenspeicher 36 zusammengefaßt.

Über die Prozessor- Bus-Schnittstelle 38 kann der Inhalt des Zwischenspeichers 36 über die Datenleitungen 42 vom Prozessor ausgelesen werden.

Mit 44 ist ein Vergleicher bezeichnet. Der Vergleicher 44 vergleicht ein digitales Frequenzäquivalent von den Zwischenspeichern 32 und 34 mit einem vorgegebenen Grenz wert. Der Grenzwert wird von dem Prozessor über die Prozessor-Bus-Schnittstelle 38 und die Datenleitungen 46 in ein Register 48 als digitales Wort eingegeben.

Mit 50 ist ein programmierbarer Zeitzähler bezeichnet, der eine Verzögerung des die Grenzwertüberschreitung anzeigenden Ausgangssignals bewirkt. Damit wird eine Signalgabe bei kurzzeitigen Störungen verhindert. Ein Zustandsspeicher in Form eines Flipflops 52 hält den Zustand "Überschreitung" oder "Nichtüberschreitung" des Grenzwertes fest. Mit 54 sind Mittel zur internen Verknüpfung äußerer Zustände bezeichnet. Über diese Mittel 54 kann die Wirkung einer Grenzwertüberschreitung durch ein äußeres Ereignis über den Eingang 55 in den Meldekanal eingeschleust werden. Die Wirkung einer Grenzwertüber schreitung kann auch von dem Prozessor durch setzen des Bit 82 im Kommandoregister 58 über die Leitung 86 ausgelöst werden. Eine Grenzwertüberschreitung kann von dem Prozessor über die Prozessor-Bus-Schnittstelle 38 durch Setzen des Bit 98 im Statusregister 88 registriert werden.

Ein Kommandoregister 58 dient zur Bestimmung und Einleitung des Wandlungsmodus.

Der Wandlerkanal 10 kann im Synchron-Modus betrieben werden. Dabei wird ein einmaliger Wandelvorgang jeweils durch den Mikroprozessor gestartet. Der Wandlerkanal 10 kann aber auch im Asynchron-Modus betrieben werden. Dann wird der Wandelvorgang einmal gestartet und wiederholt sich periodisch. Die Wahl zwischen diesen beiden Moden wird durch Bit 60 des Kommandoregisters 58 getroffen.

Bit 62 des Kommandoregisters 58 bestimmt, welcher Eingang 12 oder 14 von dem Multiplexer 16 durchgeschaltet werden soll, ob also die an dem Eingang 12 anliegende Frequenz FM1 oder die an dem Eingang 14 anliegende Frequenz FM2 gewandelt werden soll.

Bit 64 steuert ebenfalls den Multiplexer 16 und leitet einen Prüfvorgang ein. Zu diesem Zweck wird die intern durch den Oszillator 24 oder extern über den Eingang 72 erzeugte bekannte Referenzfrequenz FR über einen Frequenzteiler 66 auf einen Eingang 68 des Multiplexers 16 geschaltet.

Bit 70 des Kommandoregisters 58 steuert den Multiplexer 27 und bestimmt, ob die Referenzfrequenz FR2 vom Oszillator 24 oder eine an einem Bausteineingang 72 anliegende externe Referenzfrequenz FR1 benutzt wird.

Bit 74 des Kommandoregisters 58 bestimmt, ob die beiden Eingänge 12 und 14 des Wandlerkanals 10 im Multiplex-Modus betrieben werden oder im Redundant-Modus. Im Multiplex-Modus sind die beiden Eingänge umschaltbar durch Umprogram mierung des Bit 62 des Kommandowortes 58 durch den Prozessor. Im Redundant-Modus erfolgt eine Umschaltung durch selbständige interne Überwachung der beiden Eingänge 12 und 14. Fällt das Signal am Eingang 12 weg (Unterschreiten einer minimalen Frequenzschwelle), was durch eine Überwachungsschaltung 76 erkannt wird, dann wird durch die Überwachungsschaltung 76 der Multiplexer 16 umgeschaltet und der Eingang 14 auf den Frequenz-Digital-Wandler 18 aufgeschaltet.

Bit 78 bestimmt, ob eine Wandlung stattfinden soll oder nicht. Die Bit 80 und 82 bewirken ein Setzen bzw. Rücksetzen des eine Grenzwertüberschreitung anzeigenden Signals an dem Ausgang 56 bzw. den Mitteln 54. Das ist durch die mit "A" und "B" bezeichneten Marken an den Eingängen 84 bzw. 86 dargestellt.

Weiterhin enthält der Baustein ein Statusregister 88. Das Statusregister 88 liefert über die Datenleitungen 90 und die Mikroprozessor-Bus-Schnittstelle 38 Informationen über den augenblicklichen Zustand des Wandlerkanals 10.

Bit 92 gibt den gewählten Eingang 12 oder 14 an. Bit 94 signalisiert, ob ein Prüfvorgang läuft. Die Bit 96 und 98 geben an, ob eine Grenzwertüberschreitung gemeldet wird, wie durch die mit "C" und "D" bezeichneten Marken am Ausgang des Komparators 44 bzw. am Ausgang 100 der Mittel 54 angedeutet ist. Bit 102 signalisiert den Wandlerstatus, d.h. ob eine Wandlung läuft oder fertig ist. Bit 104 und 106 signalisieren einen Überlauf der Zähler 20 bzw. 26.

Bit 108 liefert das Ergebnis eines Vergleichs zweier Schlüsselworte. Die Schlüsselworte sollen sicherstellen, daß keine ungewollte Umprogrammierung stattfindet. Zu diesem Zweck wird vor den zu schreibenden Daten, die von der Prozessor-Bus-Schnittstelle 38 an einen Datenausgang 110 geliefert werden sollen, ein Schlüsselwort eingegeben. Dieses Schlüsselwort wird mit einem Referenzschlüsselwort durch einen Vergleicher 114 verglichen. Nur wenn die Differenz von Schlüsselwort und Referenzschlüsselwort null wird, kann der Schreib-Adress decoder 116 von der Schreibleitung 112 aktiviert werden und die Daten in einem nachfolgenden Schreibvorgang in die Register des Bausteins eingeschrieben werden. Mit 118 ist ein Lese-Adressdecoder bezeichnet.

Der Baustein enthält auch ein Bereichsregister mit den Teilen 22, 66 und 67.

Mit dem Teil 22 wird die Meßfrequenz so unterteilt, daß ein gewünschter Meßfrequenzbereich entsteht.

Mit dem Teil 66 wird die Referenzfrequenz FM auf der Leitung 28 so unterteilt, daß eine der bekannten Test-Meßfrequenzen entsteht.

Mit dem Teil 67 wird die Referenzfrequenz FM auf der Leitung 28 so unterteilt, daß auf der Ausgangsleitung 128 des Bausteines 10 eine gewünschte unterteilte Referenzfrequenz für bausteinexterne Zwecke entsteht.

Nach Programmierung der Grundfunktion an den Frequenzteilern 22, 66, 67 über Leitung 23 und an dem Kommandoregister 58 durch den Prozessor kann der Baustein zur Messung von Frequenzen und zur selbständigen Überwachung von Grenzwerten benutzt werden. Dazu programmiert der Prozessor zusätzlich den Grenzwert, der dann prozessorunabhängig überwacht wird und bei Erreichen an den Bausteinausgang des Meldekanals 56 gemeldet werden soll. Zum Schutz dieser Funktion vor ungewollter Umprogrammierung dient das Schlüsselwort und Referenz schlüsselwort. Der Prozessor-Bus-Anschluß kann außerdem durch Hochohmigsetzen mit Mitteln 122 durch einen Eingang 125 nach der Programmierung abgekoppelt werden.

Der Baustein enthält schließlich eine allein operierende Ablaufsteuerung 120 mit Fehlfunktionsanzeige 123. Eine solche allein operierende Ablaufsteuerung gestattet die prozessorunabhängige Konfigurierung des Bausteins aus einem externen Speicher.

Der Baustein kann alleinoperierend nach Setzen des Eingang 126 ohne Prozessor zur Überwachung eines Frequenz-Grenzwertes benutzt werden. Dazu lädt der Baustein beim Einschalten aus einem externen EPROM seine Konfigurationsdaten gesteuert durch diskrete Eingangslei tungen 128 selbständig ein. Diese Konfigurationsdaten sind beispielsweise der Meßbereich (z.B. 150 Hz bis 156 KHz), das Wandelverhalten (Asynchron-Modus, Redundanz-Modus), der Frequenzgrenzwert sowie die Verzögerungszeit, um welche die Aussage des Vergleichers 44 verzögert wird.

Nach Ansprechen des Vergleichers 44 wird die Verzögerungszeit durch einen Zähler bestimmt, der durch ein 8-Bit-Register 124 programmiert ist. Bei Gleichheit der Inhalte der Zwischenspeicher 32 und 34 einerseits und des den Grenzwert enthaltenden Registers 48, oder wenn der in den Zwischenspeichern 32 und 34 digital dargestellte Wert größer als der Grenzwert wird, wird der Meldekanal 56 des Bausteins aktiviert.

Durch eine Meßbereichsprogrammierung des Frequenzteilers 22 ist der Baustein in der Lage, Frequenzen von 150 Hz bis 30 MHz in etwa einer Millisekunde zu messen oder zu überwachen. Niedrigere Frequenzen sind durch Verminderung der Referenzfrequenz bei Vergrößerung der Meßzeit zu erfassen. Unterhalb der Frequenz von 1 KHz, also einer Zykluszeit von einer Millisekunde, vergrößert sich die Meßzeit mit der jeweiligen Zykluszeit.

Ein Baustein dieser Art wurde in 2-Technik mit einer Komplexizität von etwa 8 500 Gattern auf einer Fläche von 66 mm realisiert.

## Patentansprüche

1. Schaltungsanordnung zur Frequenz-Digital-Wandlung, **dadurch gekennzeichnet, daß** in einem integrierten Baustein die nachstehenden Funktionen vereinigt sind:
(a) ein Wandlerkanal (10) mit einem nach einem kombinierten Zähl- und Zeitverfahren arbeitenden Frequenz-Digital-Wandler (18) mit
- einem Flankenzähler (20), auf welchen eine an einem Eingang anliegende Meßfrequenz (FM) über einen Frequenzbereichs-Teiler (22) aufschaltbar ist,
- einem Torzeitzähler (26), auf den eine von einem bausteineigenen Taktgenerator (24) abgeleitete Referenzfrequenz aufschaltbar ist,
- wobei der Torzeitzähler (26) eine Torzeit vorgibt, während welcher der Flankenzähler (20) die daran von dem Frequenzbereichs-Teiler (22) anliegende Zählfrequenz zählt und nach dem Ende der Torzeit die Referenzfrequenz bis zum Erscheinen der nächsten Flanke der Zählfrequenz zählt, und
- die in Zwischenspeichern (32 bzw. 34) gespeicherten Zählerstände des Flankenzählers (20) und des Torzeitzählers (26) als höher-bzw. geringerwertige Stellen eines die zu wandelnde Frequenz wiedergebenden digitalen Wortes als Frequenzäquivalent in einem weiteren Zwischenspeicher (36) speicherbar sind,
(b) ein Kommandoregister (58), durch welches der Wandlungsmodus bestimmbar und einleitbar ist
(c) ein Statusregister (88), welches Information über den augenblicklichen Stand des Wandlerkanals erfaßt,
(d) eine Prozessor-Bus- Schnittstelle (38) mit Daten-, Adress- und Steuerleitungen,
- die über Datenleitungen (42 bzw. 90) mit dem Zwischenspeicher (36) zum Zugriff auf das frequenzäquivalente, digitale Wort und mit dem Statusregister (88) verbunden ist,
- die über eine Steuerleitung (23) mit dem die Meßfrequenz (FM) teilenden Frequenzbereichs-Teiler (22) verbunden ist und diesen in Abhängigkeit von einem durch einen Prozessor gegebenen Befehl derart schaltet, daß ein durch den Prozessor gewünschter Meßbereich entsteht, und
- die über Adressen- und Steuerleitungen mit dem Kommandoregister (58) zur Bestimmung des Wandlermodus durch den Prozessor verbunden ist,
(e) ein Vergleicher (44) zum Vergleichen des von dem Frequenz-Digital-Wandler (18) gelieferten, frequenzäquivalenten Wortes mit einem von dem Prozessor über die Prozessor-Bus-Schnittstelle (38) in ein Register (48) eingegebenen Grenzwert, der bei Überschreiten des Grenzwertes ein Flipflop (52) als Zustandsspeicher setzt, und
(f) eine allein operierende Ablaufsteuerung (120), mit Fehlfunktionsanzeige, die durch diskrete Eingangsleitungen gesteuert ist, zur prozessorunabhängigen Konfigurierung des Bausteins aus einem externen Speicher.

2. Schaltungsanordnung zur Frequenz-Digital-Wandlung nach Anspruch 1, **dadurch gekennzeichnet, daß** der Wandlerkanal (10) zwei Eingänge (12,14) aufweist, die durch einen Multiplexer (16) alternativ auf den Frequenz-Digital-Wandler (18) aufschaltbar sind.

3. Schaltungsanordnung zur Frequenz-Digital-Wandlung nach Anspruch 2, **dadurch gekennzeichnet, daß** der Multiplexer (16) von dem Kommandoregister (58) gesteuert ist, derart daß die Eingänge (12,14) des Wandlerkanals (10) durch Umprogrammieren des in dem Kommandoregister (58) gespeicherten Kommandowortes umschaltbar sind.

4. Schaltungsanordnung zur Frequenz-Digital-Wandlung nach Anspruch 2, **dadurch gekennzeichnet, daß** an dem einen Eingang (12) eine den Multiplexer steuernde Überwachungsschaltung (76) anliegt, welche die Meßfrequenz (FM) überwacht und bei Unterschreiten einer Mindest-Frequenz, was einen Meßwertausfall signalisiert, eine Umschaltung auf den anderen Eingang (14) auslöst.

5. Schaltungsanordnung zur Frequenz-Digital-Wandlung nach einem der Ansprüche 2 bis 4, **dadurch gekennzeichnet, daß** die Referenzfrequenz gesteuert von dem Kommandoregister (58) über einen zweiten Multiplexer (27) alternativ von dem bausteineigenen Taktgenerator (24) oder einem mit einer externen Referenzfrequenz verbindbaren Bausteineingang (72) auf den Frequenz-Digital-Wandler (18) aufschaltbar ist.

6. Schaltungsanordnung zur Frequenz-Digital-Wandlung nach Anspruch 5, **dadurch gekennzeichnet, daß** der Ausgang des zweiten Multiplexers (27) über einen durch das Kommandoregister (58) programmierbaren Frequenzteiler (66) als bekannte Testfrequenz auf einen weiteren Eingang des die Meßfrequenz-Eingänge (12,14) umschaltenden Multiplexers (16) geschaltet ist.

7. Schaltungsanordnung zur Frequenz-Digital-Wandlung nach Anspruch 6, **dadurch gekennzeichnet, daß** zu Testzwecken durch einen vom Kommandoregister gesteuerten Frequenzteiler (66) unterschiedliche, bekannte Testfrequenzen auf den weiteren Eingang des Multiplexers (16) aufschaltbar sind.

8. Schaltungsanordnung zur Frequenz-Digital-Wandlung nach einem der Ansprüche 1 bis 7, dadurch gekennzeichnet, daß die Referenzfrequenz zur Wandlung niedriger Meßfrequenzen bei Vergrößerung der Meßzeit verminderbar ist.

9. Schaltungsanordnung zur Frequenz-Digital-Wandlung nach einem der Ansprüche 1 bis 8, **dadurch gekennzeichnet, daß** zwischen den Vergleicher (44) und Flipflop (52) ein Verzögerungsglied in Form eines programmierbaren Zeitzählers (50) mit einem Verzögerungsregister (124) vorgesehen ist, so daß eine Verzögerung des eine Grenzwert-Überschreitung anzeigenden Signals bewirkt und eine Signalgabe an einem Meldekanal (56) bei kurzzeitigen Störungen verhindert wird.

10. Schaltungsanordnung zur Frequenz-Digital-Wandlung nach Anspruch 9, **dadurch gekennzeichnet, daß** dem Flipflop (52) Mittel (54) zur internen Verknüpfung äußerer Zustände mit dem Meldekanal (56) nachgeschaltet sind, durch welche in dem Meldekanal ein einer Überschreitung des Grenzwertes entsprechendes Signal erzeugbar ist.

11. Schaltungsanordnung zur Frequenz-Digital-Wandlung nach einem der Ansprüche 1 bis 10, **dadurch gekennzeichnet, daß** der Wandlerkanal, gesteuert von dem Kommandoregister (58)
- in einem Synchron-Modus betreibbar ist, in welchem durch einen Prozessor ein einmaliger Wandelvorgang einleitbar ist, oder
- in einem Asynchron-Modus betreibbar ist, in welchem ein einmal gestarteter Wandelvorgang sich automatisch wiederholt.

## Claims

1. Circuit arrangement for frequence-digital conversion **characterized in that** the following functions are united in an integrated component:
(a) a converter passage (10) having a frequence-digital converter (18) operating in accordance to a combined counting and time method, having
- an edge counter (20) to which a measuring frequency (FM) applied to an entrance is adapted to be applied through a frequency devider (22),
- a gate time counter (26) to which a reference frequency derived from a clock generator (24) proper to the component is adapted to be applied,
- the gate time counter (26) pedeterming a gate time during which the edge counter (20) counts the counter frequency applied thereto by the frequency range devider (22) and after the end of the gate time it counts the reference frequency up to the appearance of the next edge of the counting frequency, and
- the counting digits of the edge counter (20) an of the gate time counter (26) memorised in intermediate memories (32 and 34, resp.) being adapted to be memorised as superior and inferior digits, respectively, of a digital word representing the frequency to be converted as frequency equivalent in a further intermediate memory (36),
(b) a command register (58) arranged to determine and to introduce the conversion mode,
(c) a status register (88) detecting informations about the real state of the converter passage,
(d) a processor bus interface (38) having data, adress and control passages,
- connected through data passages (42 and 90, respectively) to the intermediate memory (36) for access to the frequency equivalent digital word , and to the status register (88),
- connected through a command passage (23) to the frequency range devider (22) dividing the measuring frequency (FM) and switching it in function of an instruction given by a processor such that a measuring range desired by the processor is generated, and
- connected through adress and control passages to the command register (58) for determining the converter mode by the processor,
(e) a comparator (44) for comparing the frequency-equivalent word provided by the frequency digital converter (18) to a limit introduced by the processor through the processor bus interface (38) into a register m(48), which comparator sets a flip-flop (52) as state memory when exceeding the limit, and
(f) a run-off control (120) operating individually, having a misfunction indication controled by discrete entrace passages, for processor independant configuration of the component in an external memory.

2. Circuit arrangement for frequency digital conversion as set forth in claim 1, **characterized in that** the converter passage (10) has two entrances (12,14) adapted to be applied by a multiplexer (16) alternatively to the frequency digital converter (18).

3. Circuit arrangement for frequency digital conversion as set forth in claim 2, **characterized in that** the multiplexer (16) is controled by the command register (58) such that the entrances (12, 14) of the converter passage (10) are adapted to be converted by reprogramming the command word memorised in the the command register (58).

4. Circuit arrangement for frequency digital conversion as set forth in claim 2, **characterized in that** a control circuit (76) controlling the multiplexer is applied to one of the entrances (12), which control circuit controls the measuring frequency and starts conversion to the other entrance (14) when being inferior to a minimum frequency signalizing a measuring value breakdown.

5. Circuit arrangement for frequency digital conversion as set forth in one of claims 2 to 4, **characterized in that** the reference frequency controled by the command register (58) is adapted to be applied through a second multiplexer (27) alternatively from the clock generator (24) proper to the component or a component entrance (72) connectable to an external reference frequency to the frequency digital converter (18).

6. Circuit arrangement for frequency digital conversion as set forth in claim 5, **characterized in that** the outlet of the second multiplexer (27) is applied through a frequency devider (66) programmable by the command register (58) as known test frequency to another entrance of the multiplexer (16) converting the measuring frequency entrances (12, 14).

7. Circuit arrangement for frequency digital conversion as set forth in claim 6, **characterized in that** for test purposes a frequency devider (66) controled by the command register is arranged to apply different known test frequencies to the further entrance of the multiplexer (16).

8. Circuit arrangement for frequency digital conversion as set forth in one of claims 1 to 7, **characterized in that** the reference frequency is adapted to be reduced for converting lower measuring frequencies when increasing the measuring time.

9. Circuit arrangement for frequency digital conversion as set forth in one of claims 1 to 8, **characterized in that** a time element in form of a programmable time counter (50) having a delay register (124) is provided between the comparator (44) and the flip-flop (52) such that a delay of the signal indicating that the limit is exceeded is produced and a signal feed to an answering passage (56) is prevented with short-time perturbations.

10. Circuit arrangement for frequency digital conversion as set forth in claim 9, **characterized in that** means for internal connection of outer states to the answering passage (56) are connected downstreams to the flip-flop (52), by which means a signal corresponding to the excceding of the limit is adapted to be generated in the answering passage.

11. Circuit arrangement for frequency digital conversion as set forth in one of claims 1 to 10, **characterized in that** the converter passage controled by the command register (58)
- is arranged to be operated by a synchronous mode in which a processor is adapted to introduce a one time conversion process, or
- is arranged to be operated by an asynchronous mode in which a conversion process once started repeats automatically.

## Revendications

1. Disposition de circuit destinée à la conversion de fréquences en numérique, **caractérisée par le fait que** les fonctions suivantes sont réunies dans un élément intégré :
(a) un canal de convertisseur (10) muni d'un convertisseur de fréquences en numérique (18) travaillant d'après un procédé combiné de durée et de comptage muni
- d'un compteur de flancs d'impulsion (20) auquel une fréquence de mesure (FM) adjacente à une entrée est susceptible d'être appliquée par l'intermédiaire d'un diviseur de domaine fréquentiel (22),
- d'un compteur de durée porte (26) auquel une fréquence de référence dérivée d'un générateur de cycle (24) propre à l'élément est susceptible d'être appliquée,
- le compteur de durée porte (26) prédonnant une durée porte pendant laquelle le compteur de flancs d'impulsion (20) compte la fréquence de comptage adjacence à celle du diviseur de domaine fréquentiel (22) et compte la fréquence de référence à la fin de la durée porte jusqu'à l'apparition du flanc d'impulsion suivant de la fréquence de comptage, et
- les positions de compteur du compteur de flancs d'impulsion (20) et du compteur de durée porte (26) mémorisées dans des mémoires temporaires (32 et 34 respectivement) étant susceptibles d'être mémorisées dans une autre mémoire temporaire (36) en tant que chiffres de qualité supérieure et inférieure respectivement d'un mot numérique rendant la fréquence à convertir et considéré comme équivalent fréquentiel,
(b) un registre d'instruction (58) par lequel le mode de conversion est susceptible d'être déterminé et amorcé
(c) un registre de statut (88) qui saisit des informations sur l'état momentané du canal de convertisseur
(d) une jonction de bus de processeur (38) munie de conduites de commande, d'adresse et de données
- qui est reliée par l'intermédiaire de conduites de données (42 et 90 respectivement) à la mémoire temporaire (36) afin d'accéder au mot numérique équivalent à la fréquence et reliée au registre de statut (88),
- qui est reliée par l'intermédiaire d'une conduite de commande (23) au diviseur de domaine fréquentiel (22) divisant la fréquence de mesure (FM) et qui enclenche celui-ci en fonction d'un ordre donné par un processeur de telle façon qu'il apparaît un domaine de mesure souhaité par le processeur, et
- qui est reliée par l'intermédiaire de conduites de commande et d'adresse au registre d'instruction (58) afin de déterminer le mode de conversion par le processeur,
(e) un comparateur (44) destiné à comparer le mot équivalent à la fréquence livré par le convertisseur de fréquences en numérique (18) à une valeur limite entrée dans un registre (48) par le processeur par l'intermédiaire de la jonction de bus de processeur (38) et qui met une bascule (52) en mémoire d'état lorsque la valeur limite est dépassée, et
(f) une commande séquentielle à autofonctionnement (120) munie d'un affichage pour fonctionnement anormal, commandée par des conduites d'entrée discrètes et destinée à configurer l'élément indépendamment du processeur à partir d'une mémoire externe.

2. Disposition de circuit destinée à la conversion de fréquences en numérique selon la revendication 1, **caractérisée par le fait que** le canal de convertisseur (10) présente deux entrées (12,14) qui sont susceptibles d'être appliquées alternativement au convertisseur de fréquences en numérique (18) par un multiplexeur (16).

3. Disposition de circuit destinée à la conversion de fréquences en numérique selon la revendication 2, **caractérisée par le fait que** le multiplexeur (16) est commandé par le registre d'instruction (58) de telle façon que les entrées (12,14) du canal de convertisseur (10) sont susceptibles d'être commutées en changeant la programmation du mot d'instruction mémorisé dans le registre d'instruction (58).

4. Disposition de circuit destinée à la conversion de fréquences en numérique selon la revendication 2, **caractérisée par le fait que** un circuit de contrôle (76) commandant le multiplexeur est adjacent à l'une des entrées (12), circuit qui contrôle la fréquence de mesure (FM) et qui déclenche une commutation sur l'autre entrée lorsqu'une fréquence minimale est dépassée, ce qui signalise une indisponibilité de la valeur de mesure.

5. Disposition de circuit destinée à la conversion de fréquences en numérique selon l'une des revendications 2 à 4, **caractérisée par le fait que** la fréquence de référence est susceptible d'être appliquée de facon commandée par le registre d'instruction (58) au convertisseur de fréquences en numérique (18) par l'intermédiaire d'un second multiplexeur (27) alternativement par le générateur de cycle (24) propre à l'élément ou par une entrée d'élément (72) susceptible d'être reliée à une fréquence de référence externe.

6. Disposition de circuit destinée à la conversion de fréquences en numérique selon la revendication 5, **caractérisée par le fait que** la sortie du second multiplexeur (27) est appliquée à une autre sortie du multiplexeur (16) commutant les entrées de fréquence de mesure (12,14) par l'intermédiaire d'un diviseur fréquentiel (66) susceptible d'être programmé par le registre d'instruction (58) en tant que fréquence test connue.

7. Disposition de circuit destinée a la conversion de fréquences en numérique selon la revendication 6, **caractérisée par le fait que** différentes fréquences test connues sont susceptibles d'être appliquées en vue de tests à l'autre entrée du multiplexeur (16) par un diviseur fréquentiel (66) commandé par le registre d'instruction.

8. Disposition de circuit destinée à la conversion de fréquences en numérique selon l'une des revendications 1 à 7, **caractérisée par le fait que** la fréquence de référence est susceptible d'être diminuée afin de convertir de basses fréquences de mesure lorsque la durée de mesure augmente.

9. Disposition de circuit destinée à la conversion de fréquences en numérique selon l'une des revendications 1 à 8, **caractérisée par le fait que** un membre de temporisation sous forme d'un compteur de durée (50) susceptible d'être programmé muni d'un registre de temporisation (124) est prévu entre le comparateur (44) et la bascule (52) de telle façon qu'une temporisation du signal affichant un dépassement de la valeur limite est provoquée et une transmission ce signaux située à un canal de signalisation (56) est empêchée lors de dérangements de courte durée.

10. Disposition de circuit destinée à la conversion de fréquences en numérique selon la revendication 9, **caractérisée par le fait que** des moyens (54) destinée à la liaison interne d'états extérieurs avec le canal de signalisation (56) sont appliqués après la bascule (52), moyens par lesquels un signal correspondant à un dépassement de la valeur limite est susceptible d'être généré dans le canal de signalisation.

11. Disposition de circuit destinée à la conversion de fréquences en numérique selon l'une des revendications 1 à 10, **caractérisée par le fait que** le canal de convertisseur, de façon commandée par le registre d'instruction (58),
- est susceptible d'être actionné en mode synchrone dans lequel un unique processus de conversion est susceptible d'être amorcé par un processeur, ou
- est susceptible d'être actionné en mode asynchrone dans lequel un processus de conversion mis en route une fois se répète automatiquement.
